# EUROPEAN PATENT APPLICATION

(11) **EP 2 110 856 A1**
(43) Date of publication of application: **21.10.2009**
(21) Application number: 08710726.4
(22) Date of filing: 28.01.2008
(51) Int. Cl.: H01L 29/786, H01L 21/336, H01L 51/05

(54) **THIN FILM SEMICONDUCTOR DEVICE FABRICATION METHOD AND THIN FILM SEMICONDUCTOR DEVICE**

(30) Priority: 29.01.2007 JP 2007017454
(71) Applicant: Sony Corporation, Tokyo 108-0075 (JP); Riken, Wako-shi, Saitama 351-0198 (JP)
(72) Inventor: NOMOTO, Kazumasa, Tokyo 108-0075 (JP); HIRAI, Nobukazu, Tokyo 108-0075 (JP); YASUDA, Ryoichi, Tokyo 108-0075 (JP); YAGI, Iwao, Tokyo 108-0075 (JP); MINARI, Takeo, Wako-shi Saitama 351-0198 (JP); TSUKAGOSHI, Kazuhito, Wako-shi Saitama 351-0198 (JP); AOYAGI, Yoshinobu, Wako-shi Saitama 351-0198 (JP)
(74) Representative: Müller - Hoffmann & Partner
(86) International application number: PCT/JP2008/051696
(87) International publication number: WO 2008/093854

(57) **Abstract**

The present invention provides a method for making a thin film semiconductor device having a bottom-gate, bottom-contact-type thin film transistor structure finer in size with satisfactory characteristics, in which the interface between a gate insulating film and a thin film semiconductor layer can be maintained at satisfactory conditions without being affected by formation of source/drain electrodes. A first gate insulating film (7-1) covering a gate electrode (5) on a substrate (3) is formed, and a pair of source/drain electrodes (9) is formed on the first gate insulating film (7-1). Subsequently, a second gate insulating film (7-2) is selectively formed only on the first gate insulating film (7-2) exposed from the source/drain electrodes (9). Next, a thin film semiconductor layer (11) continuously covering from the source/drain electrodes (9) to the first gate insulating film (7-1) through the second gate insulating film (7-2) is formed while making contact with the source/drain electrodes (9). A method for making a thin film semiconductor device (1) is **characterized** as such.

## Description

### Technical Field

The present invention relates to a method for making a thin film semiconductor device and a thin film semiconductor device, in particular, to a method for making a thin film semiconductor device suitable for fabrication of a bottom-gate type that uses an organic semiconductor layer, and a thin film semiconductor device obtained thereby.

### Background Art

Thin film transistors are being widely used as driving elements in thin electronic substrates, in particular, active matrix-type thin display devices. In recent years, semiconductor devices that use organic semiconductors as active layers have attracted attention. Semiconductor devices that use organic semiconductors are advantageous in terms of cost reduction since active layers composed of organic semiconductors can be formed by application at low temperatures, and can be formed on flexible substrates having no heat resistance, such as plastics and the like. Not only active layers but also gate insulating films, source/drain electrodes, and gate electrodes can be formed by patterning through a printing technique using an application-type materials; thus, further cost reduction can be achieved.

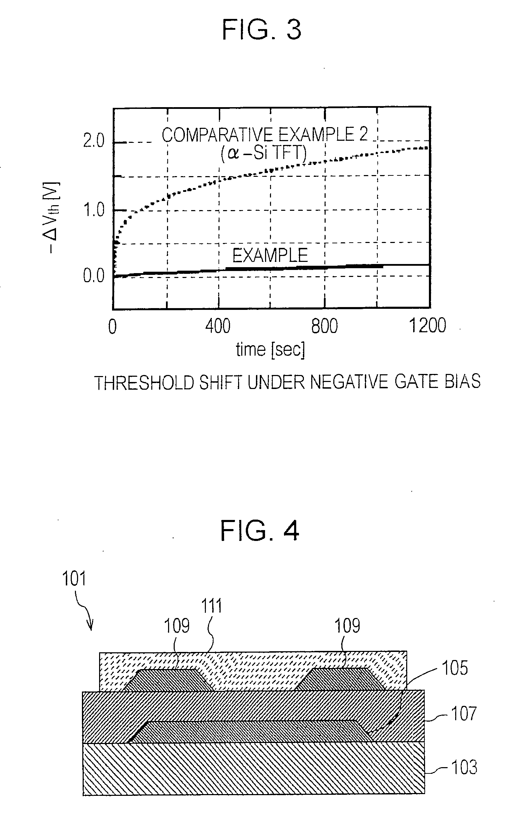

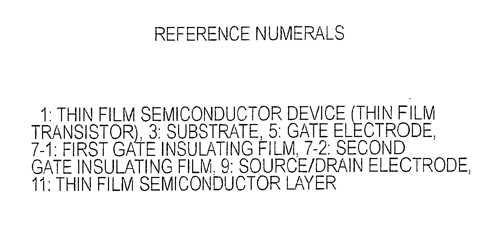

In the mean time, in forming finer thin film transistors using organic semiconductors, it is advantageous to form a bottom-gate, bottom-contact-type. As shown in Fig. 4, a thin film transistor 101 of a bottom-gate, bottom-contact type has a structure in which a gate electrode 105, a gate insulating film 107, source/drain electrodes 109, and a thin film semiconductor layer 111 are stacked in that order on a substrate 103. Thus, even in the case where a resist pattern is formed by employing a photolithographic technique capable of forming fine patterns and the gate electrode 105 and the source/drain electrodes 109 are formed by pattern etching using that as a mask, the thin film semiconductor layer 111 composed of an organic semiconductor remains unexposed to an organic solvent subsequently used for removing the resist pattern. Therefore, the film quality of the thin film semiconductor layer 111 that serves as an active layer can be satisfactorily maintained (refer to Non-Patent Document 1 below for the description heretofore).
Non-Patent Document 1: K. Nomoto et. al., IEEE Transactions on Electron Devices, (2005), vol. 52, p. 1519-p. 1526

However, as shown in Fig. 4, since the bottom-gate, bottom-contact-type thin film transistor has a structure in which the source/drain electrodes 109 are disposed on the gate insulating film 107, the step of forming the source/drain electrodes 109 affects the surface of the gate insulating film 107. Consequently, for example, when the gate insulating film 107 is composed of an organic material, the gate insulating film 107 becomes exposed to an organic solvent for removing the resist pattern used for forming the pattern of the source/drain electrodes 109, and it becomes difficult to maintain the film quality of the surface layer which forms the interface with the thin film semiconductor layer 111. Moreover, such deterioration of the interface between the gate insulating film 107 and the thin film semiconductor layer 111 becomes the factor that inflicts problems such as threshold shifts, a mobility decrease, etc.

### Disclosure of Invention

In view of the above, an object of the present invention is to provide a method for making a thin film semiconductor device having a bottom-gate, bottom-contact-type thin film transistor structure finer in size with satisfactory characteristics, in which the interface between a gate insulating film and a thin film semiconductor layer can be maintained at satisfactory conditions without being affected by formation of the source/drain electrodes, and to provide a thin film semiconductor device obtained by this method.

According to a method for making a thin film semiconductor device of the present invention for achieving the objects described above, after a first gate insulating film covering a gate electrode on a substrate is formed and a pair of source/drain electrodes is formed on the first gate insulating film, a second gate insulating film is selectively formed only on the first gate insulating film exposed from the source/drain electrodes. Next, a thin film semiconductor layer continuously covering from the source/drain electrodes to the first gate insulating film through the second gate insulating film is formed while making contact with the source/drain electrodes.

According to this making method, the second gate insulating film formed after the source/drain electrodes is not affected by formation of the source/drain electrodes, and the film quality of the second gate insulating film is maintained. Moreover, since the thin film semiconductor layer is formed on the source/drain electrodes and the second gate insulating film, the interface between the second gate insulating film in which the film quality is maintained and the thin film semiconductor layer serves as a channel interface. Furthermore, formation of the source/drain electrodes does not affect the thin film semiconductor layer, either. Thus, the channel interface maintained at satisfactory conditions and the thin film semiconductor layer can be obtained on the gate insulating film covering the gate electrode without being affected by formation of the source/drain electrodes.

Furthermore, the present invention also involves a thin film semiconductor device obtained by the above-described method and has the following features. That is, the thin film semiconductor device includes a gate insulating film covering a gate electrode on a substrate, source/drain electrodes disposed on the gate insulating film, and a thin film semiconductor layer continuously covering from the source/drain electrodes to the gate insulating film. Among these, the gate insulating film has a multilayer structure including a first gate insulating film and a second gate insulating film on the first gate insulating film. Moreover, the first gate insulating film covers the gate electrode and is provided with the source/drain electrodes thereon. In contrast, the second gate insulating film is a film selectively formed only on the first gate insulating film exposed from the source/drain electrodes at least between the source/drain electrodes.

As described above, according to the present invention, the channel interface maintained at satisfactory conditions and the thin film semiconductor layer can be obtained on the gate insulating film covering the gate electrode, without being affected by formation of the source/drain electrodes. Thus, even when organic materials are used in the gate insulating film and the thin film semiconductor layer using organic materials, the conditions of the channel interface and the thin film semiconductor layer can be satisfactorily maintained without being affected by removal of the resist pattern after formation of fine source/drain electrodes by employing a lithographic technique, for example, and it becomes possible to obtain a thin film semiconductor device having a bottom-gate, bottom-contact-type thin film transistor structure finer in size with satisfactory characteristics.

### Brief Description of Drawings

Fig. 1 includes cross-sectional step diagrams illustrating an embodiment of a making method according to the present invention.
Fig. 2 includes diagrams showing a structure of an embodiment of a thin film semiconductor device of the present invention.
Fig. 3 is a graph showing amounts of changes in threshold shift of thin film transistors of Example and Comparative Example 1 with time.
Fig. 4 is a cross-sectional view showing the structure of a thin film transistor of existing art.

### Best Modes for Carrying Out the Invention

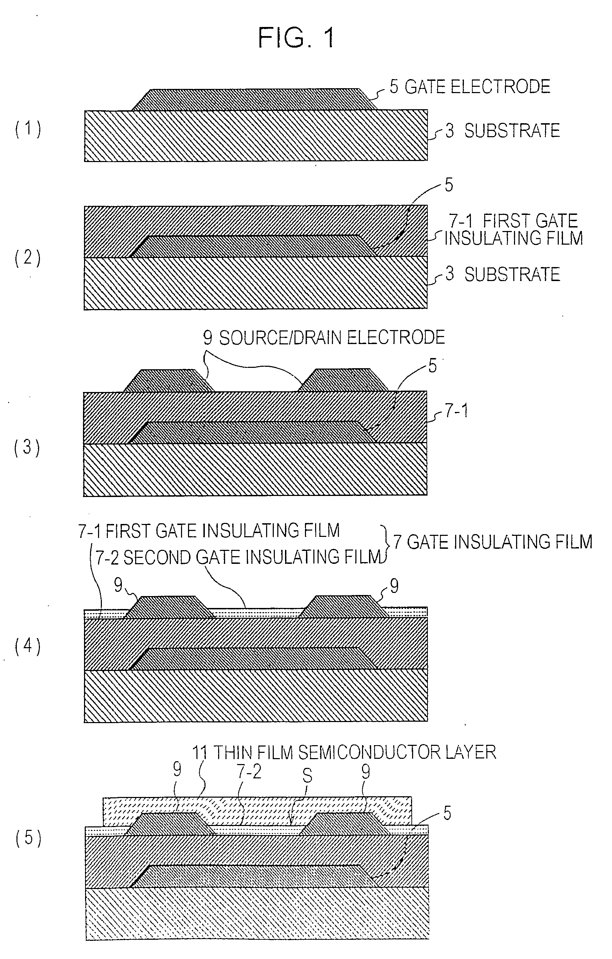

Embodiments of the present invention will now be described in detail with reference to the drawings. Here, a method for making a thin film semiconductor device in which the present invention is employed is described first using Fig. 1, and then the structure of a thin film semiconductor device obtained by this making method is described.

### <First Embodiment>

First, as shown in Fig. 1(1), a substrate 3 is prepared. Here, a plastic substrate such as polyethylene terephthalate (PET), polyethersulfone (PES), polyethylene naphthalate (PEN), or the like, a glass substrate, or a stainless-steel substrate is used.

A gate electrode 5 is formed on such a substrate 3. Formation of the gate electrode 5 is conducted, for example, by forming a metal film and pattern-etching the metal film using a photolithographically formed resist pattern as a mask. The metal film may be formed by employing a film forming method suitable for the material.

In the case of a metal film such as Al, Cu, Au, Ni, W, Mo, or the like, sputtering deposition can be employed. Furthermore, in the case of a metal film such as Au, Ag, Ni, Pd, Cr, or the like, plating deposition and vapor deposition can be employed. Then, after the metal film has been pattern-etched using the resist pattern as a mask, the resist pattern is removed. A finer gate electrode 5 can be formed by employing such a lithographic technique.

Alternatively, the gate electrode 5 may be formed by employing a printing technique, such as a screen-printing technique, a micro contact technique, or an ink jet technique using a nanoparticle dispersion of Au, Ag, or the like, a metal complex solution, or a conductive molecule solution.

Next, as shown in Fig. 1(2), a first gate insulating film 7-1 covering the gate electrode 5 on the substrate 3 is formed. Here, the first gate insulating film 7-1 is formed, for example, by application of an organic insulating film solution, in which an organic insulating film material is dissolved in an organic solvent, through a technique such as spin-coating, slit-coating, or the like. For example, it is possible to use an organic insulating film solution such as a polyimide dissolved in N-methylpyrrolidone (NMP), polyvinyl phenol (PVP) dissolved in polyethylene glycol methyl ether acrylate (PEGMEA), poly(α-methylstyrene), or the like. As a result of what is described above, the first gate insulating film 7-1 composed of an organic material is formed. Note that the first gate insulating film 7-1 formed as described above is preferably composed of an organic material, such as a polyimide, PVP, poly(α-methylstyrene), or the like, that has high adhesiveness to the source/drain electrodes (9) and stable surface conditions.

Next, as shown in Fig. 1(3), a pair of source/drain electrodes 9 is formed on the first gate insulating film 7-1, at positions sandwiching the gate electrode 5. The source/drain electrodes 9 may be formed in the same manner as the formation of the gate electrode 5. In such a case, as in the case of forming the gate electrode, finer source/drain electrodes are formed by a method employing a lithographic technique.

Subsequently, as shown in Fig. 1(4), a step of selectively forming a second gate insulating film 7-2 only on the first gate insulating film 7-1 exposed from the source/drain electrodes 9 is conducted. During this, vapor deposition is used to selectively form the second gate insulating film 7-2 only on the first gate insulating film 7-1.

The second gate insulating film 7-2 described above is formed by using a film-forming material that can achieve film formation in which the incubation time for vapor deposition on the source/drain electrodes 9 is sufficiently long relative to the incubation time (including zero) for vapor deposition on the first gate insulating film 7-1. The selective formation of the second gate insulating film 7-2 is conducted by vapor-depositing the second gate insulating film 7-2 only on the first gate insulating film 7-1 during the incubation time for the vapor deposition of the second gate insulating film 7-2 on the source/drain electrodes 9. Note that the incubation time is the period from the start of the film formation during which the thickness of the film formed remains zero.

Here, for example, the source/drain electrodes 9 are composed of a metal material and the first gate insulating film 7-1 is composed of an organic material; thus, the second gate insulating film 7-2 is selectively formed on the first gate insulating film 7-1 by vapor depositing polyparachloroxylylene (parylene-C) or polyparaxylylene (parylene-N) as the second gate insulating film 7-2.

The above-described parylene-C or parylene-N is not formed on Au, Cu, Ni, Pt, or Ag during the time in which a 10-nm-thick film is formed on a base having no incubation time for vapor deposition (refer to literature, Kathleen M. Vaeth and Klavs F. Jensen, Chem. Mater., 12, 1305-1313 (2000)). Thus, a film can be easily selectively formed on the first gate insulating film 7-1 composed of an organic material while having the source/drain electrodes 9 using Au, Cu, Ni, Pt, or Ag exposed.

Furthermore, in addition to parylene-C and parylene-N, polyparaxylylene derivatives (alkylene-phenylene-based resins) having a fluorine group or an amino group can be used as the second gate insulating film 7-2 to be selectively formed by vapor deposition on the first gate insulating film 7-1 composed of an organic material.

The selective vapor deposition of the second gate insulating film 7-2 on the first gate insulating film 7-1 composed of an organic material may be a so-called chemical vapor deposition (CVD). Such film formation is conducted by, for example, supplying a source gas containing parylene-C or parylene-N pyrolyzed at 600°C ±150°C into a reaction chamber containing the substrate 3 and vacuumed to a pressure of 0.1 Pa or less. During this, overheating and cooling of the substrate is conducted as needed, but film formation is possible at room temperature.

Note that film formation is preferably conducted so that the thickness of the second gate insulating film 7-2 selectively formed only on the first gate insulating film 7-1 as described above is within the range of thicknesses of a film formed on the first gate insulating film 7-1 before continuous deposition of the second gate insulating film 7-2 starts on the source/drain electrodes. This thickness depends on the combination of the material of the source/drain electrodes 9, the first gate insulating film 7-1, and the second gate insulating film 7-2 but is typically in the range of 1 nm or more and 100 nm or less.

Subsequently, as shown in Fig. 1(5), a thin film semiconductor layer 11 is formed on the source/drain electrodes 9 and the second gate insulating film 7-2. Here, a thin film semiconductor layer 11 having a shape that continuously covers from the source/drain electrodes 9 to the first gate insulating film 7-1 through the second gate insulating film 7-2 is formed. The thin film semiconductor layer 11 is, for example, an organic semiconductor film that uses an organic material.

Such a thin film semiconductor layer 11 is formed by a deposition technique or an application technique, such as spin coating, ink jet printing, or the like, by using an organic semiconductor (an acene, an acene derivative, a poriphyrin, a porphyrin derivative, an oligothiophene, a thiophene polymer, etc.).

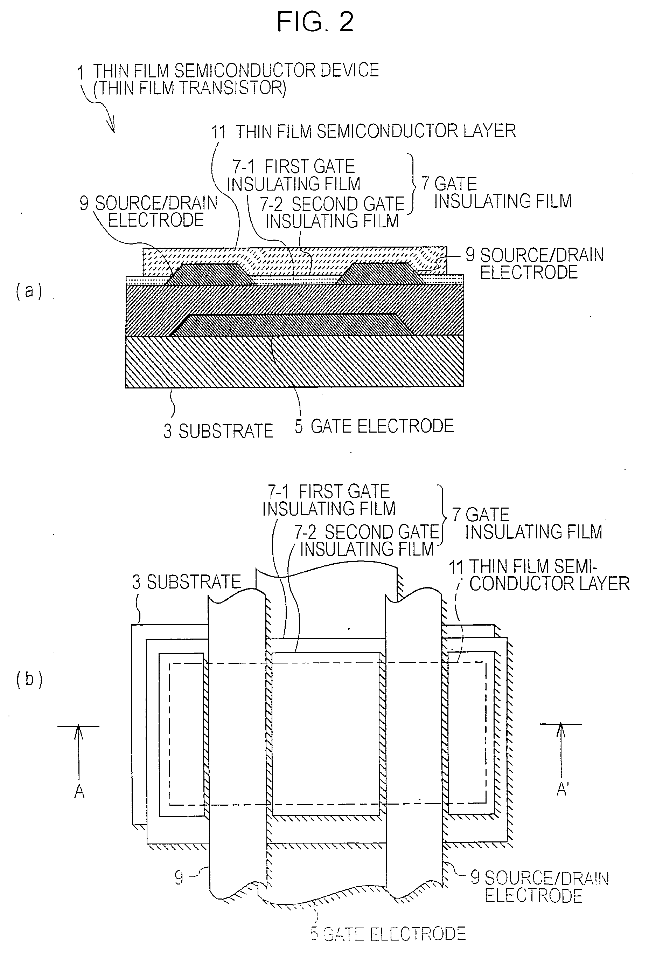

As a result of what is described above, a bottom-gate, bottom-contact-type thin film transistor such as one shown in Fig. 2 is formed as a thin film semiconductor device 1. Note that the plan view of Fig. 2(a) corresponds to an A-A' cross-section in the plan view of Fig. 2(b).

Moreover, subsequent to what is described above, wires are formed in an interlayer insulating film to achieve higher integration and multilevel wiring for the thin film semiconductor device depending on the usage, and then a sealing film is formed. The sealing film is, for example, formed to a thickness of several micrometers with an alkylene-phenylene-based resin such as polyparachloroxylylene (parylene-C) by a CVD technique. Note that the sealing film is not limited to the alkylene-phenylene-based resin, and anything that has a sealing effect, e.g., glass, an acryl or epoxy-based resin, silicon nitride (SiNx), or the like, may be used.

The thin film semiconductor device 1 obtained as such is of a bottom-gate, bottom-contact type including a gate insulating film 7 covering the gate electrode 5 on the substrate 3, the pair of source/drain electrodes 9 disposed on the gate insulating film 7, and the thin film semiconductor layer 11 that continuously covers from the source/drain electrodes 9 to the gate insulating film 7. Moreover, the gate insulating film 7 has a multilayer structure including the first gate insulating film 7-1 and the second gate insulating film 7-2. The first gate insulating film 7-1 covers the gate electrode 5 and is provided with the source/drain electrodes 9 thereon. Thus, in particular, the second gate insulating film 7-2 is a film selectively formed only on the first gate insulating film 7-1 exposed from the source/drain electrodes 9 and between the source/drain electrodes 9.

According to the first embodiment described above, as described using Fig. 1(4), the structure is such that while having the source/drain electrodes 9 already formed on the first gate insulating film 7-1, the second gate insulating film 7-2 is selectively formed on the first gate insulating film 7-1 exposed from the source/drain electrodes 9. Thus, the formation of the source/drain electrodes 9 does not affect the second gate insulating film 7-2, and the film quality of the second gate insulating film 7-2 is maintained. Moreover, since the thin film semiconductor layer 11 is formed over the source/drain electrodes 9 and the second gate insulating film 7-2 in the step shown in the next drawing, Fig. 1(5), formation of the source/drain electrodes 9 does not affect the thin film semiconductor layer 11, either. Thus, the interface between the second gate insulating film 7-2 maintaining the film quality and the thin film semiconductor layer 11 serves as a channel interface S.

Accordingly, the channel interface S maintained at a satisfactory condition without being affected by the formation of the source/drain electrodes 9, and the thin film semiconductor layer 11 can be obtained. In particular, even when fine source/drain electrodes 9 are formed by employing a lithographic technique, the surface of the gate insulating film 7 (that is, the surface of the second gate insulating film 7-2) composed of the organic material and the thin film semiconductor layer 11 are prevented from being exposed to the organic solvent used in subsequent removal of the resist pattern. As a result, a thin film semiconductor device having a bottom-gate, bottom-contact-type thin film transistor structure finer in size with satisfactory characteristics can be obtained.

### <Second Embodiment>

A second embodiment is an example in which the first gate insulating film 7-1 formed in the first embodiment is changed to a multilayer structure including an inorganic insulating film such as silicon oxide (SiOx), silicon nitride (SiNx), or the like and an organic insulating film thereon, and other structures are the same as in the first embodiment.

Silicon oxide (SiOx), silicon nitride (SiNx), and the like that have particularly high reliability against the gate leakage and electrical current stresses are preferably used as the inorganic insulating film. Such an inorganic insulating film is formed by sputtering or plasma-enhanced CVD (PECVD: chemical vapor deposition). Moreover, the organic material constituting the first gate insulating film 7-1 described in the first embodiment is used as the organic insulating film, and, similarly, a polyimide, PVP, poly(α-methylstyrene), or the like that has particularly high adhesiveness to the source/drain electrodes 9 and stable surface conditions is preferably used.

In such a case also, the steps subsequent to formation of the first gate insulating film 7-1 may be conducted as described in the first embodiment.

According to the second embodiment, in addition to the effects achieved by the first embodiment, reduction of gate leakage and improvements in reliability against electrical current stresses can be achieved by using, as the first gate insulating film 7-1, an inorganic insulating film, such as silicon oxide (SiOx), silicon nitride (SiNx), or the like, that has high reliability against gate leakage and electrical current stresses.

### <Third Embodiment>

A third embodiment is a method of selectively forming the second gate insulating film 7-2 described using Fig. 1(4) in the first embodiment through film formation by application. The making method of the third embodiment is described below using Fig. 1.

First, the steps shown in Fig. 1(1) and Fig. 1(2) are conducted as described in the first embodiment to form the gate electrode 5 on the substrate 3 and cover the gate electrode 5 with the first gate insulating film 7-1 composed of an organic material. Similarly, a polyimide, PVP, poly(α-methylstyrene), or the like that has particularly high adhesiveness to the source/drain electrodes 9 and stable surface conditions is preferably used as the organic material constituting the first gate insulating film 7-1.

Next, when forming the source/drain electrodes 9 on the first gate insulating film 7-1 in the step shown in Fig. 1(3), the source/drain electrodes 9 are formed using a material that has liquid repellency against a solution of the material for the second gate insulating film (7-2) formed in the next step.

In this case, a mixture liquid in which molecules that repel an organic solvent having an alkyl chain, a fluorine-substituted alkyl chain, or the like, i.e., a solution of the material for the second gate insulating film 7-2, are mixed with a metal nanoparticle (e.g., Ag nanoparticle) dispersion, a metal complex solution, a conductive molecule solution, or the like is used. Alkanethiols and thiol compounds containing perfluoro groups (a.k.a. silane coupling agents) are used as the molecules that repel the organic solvent having an alkyl chain, a fluorine-substituted alkyl chain, or the like. Then, the pattern of the source/drain electrodes 9 is formed by employing a printing technique such as an ink jet technique, a micro contact technique, a screen-printing technique, or the like using such a mixture liquid.

Note that the mixture liquid may further contain a polymer material containing an alkanethiol or a perfluoro group.

Note that the source/drain electrodes 9 may be formed by forming a film of the mixture liquid on the first gate insulating film 7-1 by application and then pattern-etching the applied film using a photolithographically prepared resist pattern as a mask. Finer source/drain electrodes 9 are formed by employing such a lithographic technique.

Subsequently, in selectively forming the second gate insulating film 7-2 only on the first gate insulating film 7-1 exposed from the source/drain electrodes 9 in the step shown in Fig. 1(4), an organic insulating film solvent is applied as an application liquid. Due to this, the surfaces of the source/drain electrodes 9 repel the organic insulating film solvent, the organic insulating film solvent is allowed to adsorb only on the first gate insulating film 7-1, a film of the organic insulating film solvent is selectively formed by application only on the first gate insulating film 7-1 exposed from the source/drain electrodes 9, and this film is used as the second gate insulating film 7-2.

During this, a solvent containing a molecule material having an alkyl chain or a perfluoro group is used as the organic insulating film solvent. Since the alkyl chain or perfluoro group forms a surface state having a low surface energy, the organic insulating film solvent is repelled on the source/drain electrodes 9, and it becomes possible to form a film only on the first gate insulating film 7-1 composed of the organic material. As a result, an organic insulating film such as a polyimide, polyvinyl phenol (PVP), poly(α-methylstyrene), a fluororesin obtained by cyclic polymerization of perfluoro(4-vinyloxy-1-butene), or the like is obtained, for example. Among these, a second gate insulating film 7-2 composed of a polyimide, PVP, poly(α-methylstyrene), or a fluororesin obtained by cyclic polymerization of perfluoro(4-vinyloxy-1-butene) that has good adhesiveness to a thin film semiconductor layer (11) formed next is preferably formed.

Note that the second gate insulating film 7-2 formed here is preferably formed to a thickness in the range of 1 nm or more and 100 nm or less as in the first embodiment; and, for example, the thin film is formed to a thickness of 50 nm or less. Since a typical thickness of the first gate insulating film in an organic transistor is 300 to 1000 nm, as long as the thickness range of the second gate insulating film 7-2 is in the above-described range, the driving performance of the transistor is not severely affected even when the gate capacity is decreased by an increased thickness of the gate insulating film because formation of the second gate insulating film 7-2 improves mobility due to improved quality of the gate insulating film/organic semiconductor interface.

Subsequently, the step shown in Fig. 1(5) is conducted as described in the first embodiment to form a thin film semiconductor layer 11 composed of an organic material and having a shape that continuously covers from the pair of source/drain electrodes 9 to the first gate insulating film 7-1 through the second gate insulating film 7-2.

As a result, a bottom-gate, bottom-contact-type thin film semiconductor device 1 similar to the first embodiment is made. This thin film semiconductor device 1 includes the gate insulating film 7 including a first gate insulating film 7-1 that covers the gate electrode 5 and is provided with the source/drain electrodes 9 thereon, and a second gate insulating film 7-2 selectively formed only on the first gate insulating film 7-1 exposed from the source/drain electrodes 9 and between the source/drain electrodes 9.

According to the third embodiment described above, as described using Fig. 1(4), the structure is such that the second gate insulating film 7-2 is selectively formed on the first gate insulating film 7-1 exposed from the source/drain electrodes 9 while having the source/drain electrodes 9 already formed on the first gate insulating film 7-1. Thus, the same effects as the first embodiment are obtained, and a thin film semiconductor device having a bottom-gate, bottom-contact-type thin film transistor structure finer in size with satisfactory characteristics can be obtained.

In addition to the effects described above, improvements of element characteristics can also be expected since the second gate insulating film 7-1 constituting the surface of the gate insulating film 7 can be formed using a polyimide, PVP, poly(α-methylstyrene), or a fluororesin obtained by cyclic polymerization of perfluoro(4-vinyloxy-1-butene) that has good adhesiveness to the thin film semiconductor layer 11 composed of an organic material.

### <Fourth Embodiment>

A fourth embodiment is an example in which the first gate insulating film 7-1 formed in the third embodiment is changed to an inorganic insulating film, and other structures are the same as in the second embodiment. Silicon oxide (SiOx), silicon nitride (SiNx), and the like that have particularly high reliability against the gate leakage and electrical current stresses are preferably used as the inorganic insulating film. Such an inorganic insulating film is formed by sputtering or plasma-enhanced CVD (PECVD: chemical vapor deposition).

In such a case also, the steps subsequent to formation of the first gate insulating film 7-1 may be conducted as described in the third embodiment.

According to the fourth embodiment, in addition to the effects obtained by the third embodiment, reduction of gate leakage and improvements in reliability against electrical current stresses can be achieved by using, as the first gate insulating film 7-1, an inorganic insulating film, such as silicon oxide (SiOx), silicon nitride (SiNx), or the like, that has particularly high reliability against gate leakage and electrical current stresses.

### <Fifth Embodiment>

A fifth embodiment is an example in which the first gate insulating film 7-1 formed in the third embodiment is changed to a multilayer structure including an inorganic insulating film such as silicon oxide (SiOx), silicon nitride (SiNx), or the like and an organic insulating film thereon, and other structures are the same as in the third embodiment. The organic insulating film constituting the surface layer of the first gate insulating film 7-1 may be the same as the first gate insulating film 7-1 of the third embodiment, but, in particular, a polyimide, PVP, poly(α-methylstyrene), or the like having high adhesiveness to the source/drain electrodes 9 and stable surface conditions is preferably used. Note that the structure may be such that an organic insulating film is sandwiched between inorganic insulating films constituting the lower layer of the first gate insulating film 7-1, if needed.

In such a case also, the steps subsequent to formation of the first gate insulating film 7-1 may be conducted as described in the third embodiment.

According to the fifth embodiment, reduction of gate leakage and improvements in reliability against electrical current stresses can be achieved by using, as the first gate insulating film 7-1 of the third embodiment, an inorganic insulating film, such as silicon oxide (SiOx), silicon nitride (SiNx), or the like, that has particularly high reliability against gate leakage and electrical current stresses. Furthermore, since a polyimide, PVP, poly(α-methylstyrene), or the like having high adhesiveness to the source/drain electrodes 9 and stable surface conditions can be used as the surface layer of the first gate insulating film 7-1, an additional effect of preventing separation of the source/drain electrodes 9 can be achieved.

### <Examples>

A thin film semiconductor device was made as below by employing the first embodiment (refer to Fig. 1).

First, since this example aims to confirm the effects of forming the second gate insulating film, for the gate electrode that has no influence on these effects, a substrate 3 composed of single crystal silicon heavily doped with an impurity to reduce the resistance was prepared and used to also serve as the gate electrode 5.

The first gate insulating film 7-1 was formed by applying a solution, in which polyvinyl phenol (PVP) dissolved in octadecyltrichlorosilane (OTS) was mixed with a silane coupling agent as a cross-linking agent, by spin coating on the substrate 3 that also served as the gate electrode.

Then the source/drain electrodes 9 composed of Au having a thickness of 50 nm were formed on the first gate insulating film 7-1 by employing a lithographic technique.

Subsequently, the second gate insulating film 7-2 composed of parylene-C was selectively formed by a CVD technique on the first gate insulating film 7-1 exposed from the source/drain electrodes 9.

Next, the organic thin film semiconductor layer 11 composed of pentacene was formed to a thickness of 100 nm by a deposition technique. During this, the pattern of the thin film semiconductor layer 11 was formed so that the channel width was 50 mm.

As a result, the thin film semiconductor device 1 of a bottom-gate, bottom-contact-type of Example was obtained.

### <Comparative Example 1>

As Comparative Example 1, a bottom-gate, bottom-contact-type thin film semiconductor device having an existing structure was obtained by the process of Example described above but without formation of the second gate insulating film 7-2.

### <Evaluation Results 1>

Table 1 below shows the carrier mobility and the amount of change in threshold shift after stress application (-ΔVth: amount of change observed by assuming the value observed immediately after voltage application to be the initial threshold) observed from thin film semiconductor devices 1 prepared in Example and Comparative Example 1 above. The stresses applied were gate voltage Vg = -30 V and drain voltage Vd = -5 V.

**(Table 1)**

| | Carrier mobility (cm2/Vs) | Threshold shiftafter stress [-ΔV] |
|---|---|---|
| Example | 0.14 | -0.14 |
| Comparative Example 1 | 0.10 | -2.7 |

| | | |
|---|---|---|
| Stress: Vg = -30 V, Vd = -5 V, 1000 seconds | | |

On the basis of these results, the effect of improvements of element characteristics was confirmed for both the carrier mobility and the threshold shift in Example in which the second gate insulating film 7-2 was formed by employing the present invention compared to Comparative Example 1 having an existing structure that lacked this film.

### <Comparative Example 2>

As Comparative Example 2, a thin film transistor (a.k.a. α-Si TFT) that used, as an active layer, amorphous silicon (a-Si) having the same channel length of 5 µm and channel width of 50 mm as in Example was fabricated.

### <Evaluation Results 2>

Fig. 3 shows the change in threshold shift with time under application of stresses observed from the thin film semiconductor devices 1 prepared in Example and Comparative Example 2 above. The stresses applied were gate voltage Vg = -30 V and drain voltage Vd = -5 V, and the amount of change in threshold shift (-ΔVth: amount of change observed by assuming the value observed immediately after voltage application to be the initial threshold) with time was indicated.

These results confirmed that Example in which the second gate insulating film 7-2 was formed by employing the present invention exhibited a significantly smaller threshold shift and higher reliability than the α-Si TFT of the same specifications. In particular, the amount of change in threshold shift after 1000 seconds [sec] was -0.14 V for the thin film transistor of Example in contrast to - 1.8 V for α-Si TFT.

## Claims

1. A method for making a thin film semiconductor device **characterized in that**
after a first gate insulating film covering a gate electrode on a substrate is formed and a pair of source/drain electrodes is formed on the first gate insulating film,
a second gate insulating film is selectively formed only on the first gate insulating film exposed from the source/drain electrodes, and
a thin film semiconductor layer continuously covering from the source/drain electrodes to the first gate insulating film through the second gate insulating film is formed while making contact with the source/drain electrodes.

2. The method for making a thin film semiconductor device according to Claim 1, **characterized in that**
the second gate insulating film is formed by vapor deposition, and
the second gate insulating film is vapor-deposited only on the first gate insulating film during an incubation time for vapor deposition of the second gate insulating film on the source/drain electrodes.

3. The method for making a thin film semiconductor device according to Claim 2, **characterized in that**
the vapor deposition of the second gate insulating film composed of a polyparaxylylene derivative is conducted on exposed surfaces of the first gate insulating film constituted by using an organic material and the source/drain electrodes constituted by using a metal material.

4. The method for making a thin film semiconductor device according to Claim 1, **characterized in that**
the second gate insulating film is formed by application, and
while an application liquid is being repelled at surfaces of the source/drain electrodes, the application liquid is allowed to adsorb only on a surface of the first gate insulating film.

5. The method for making a thin film semiconductor device according to Claim 4, **characterized in that**
the formation of the second gate insulating film by application is conducted on exposed surfaces of the first gate insulating film constituted by using an organic material and the source/drain electrodes containing a silane coupling agent, by applying an organic insulating film solvent serving as the application liquid.

6. A thin film semiconductor device comprising a gate insulating film covering a gate electrode on a substrate, a pair of source/drain electrodes disposed on the gate insulating film, and a thin film semiconductor layer continuously covering from the source/drain electrodes to the gate insulating film, **characterized in that**
the gate insulating film includes
a first gate insulating film covering the gate electrode and provided with the source/drain electrodes thereon, and
a second gate insulating film selectively formed only on the first gate insulating film exposed from the source/drain electrodes at least between the source/drain electrodes.

7. The thin film semiconductor device according to Claim 6, **characterized in that**
a dielectric constant of the second gate insulating film is smaller than a dielectric constant of the first gate insulating film.

8. The thin film semiconductor device according to Claim 6, **characterized in that**
the first gate insulating film is composed of an inorganic material and the second gate insulating film is composed of an organic material.

9. The thin film semiconductor device according to Claim 6, **characterized in that**
the thin film semiconductor layer is composed of an organic material.

10. The thin film semiconductor device according to Claim 6, **characterized in that**
the first gate insulating film and the second gate insulating film are composed of organic materials.
